Europäisches Patentamt

European Patent Office

Office européen des brevets

(19)

(11) **EP 0 949 831 A1**

(12) **EUROPEAN PATENT APPLICATION**

(43) Date of publication:
13.10.1999 Bulletin 1999/41

(51) Int. Cl.⁶: **H04Q 7/34**, G01S 13/90,
G01R 29/08

(21) Application number: 98106337.3

(22) Date of filing: 07.04.1998

(84) Designated Contracting States:
**AT BE CH CY DE DK ES FI FR GB GR IE IT LI LU
MC NL PT SE**
Designated Extension States:
**AL LT LV MK RO SI**

(71) Applicant: **EUROPEAN COMMUNITY
2920 Luxembourg (LU)**

(72) Inventor: **Rudolf, Hans
55127 Mainz (DE)**

(74) Representative:
**Weinmiller, Jürgen
SPOTT & WEINMILLER
European Patent Attorneys
Lennéstrasse 9
82340 Feldafing (DE)**

(54) **A method for measuring the field strength map of a HF-Broadcast transmitter**

(57) This invention relates to the measurement of the field strength map of a HF broadcast transmitter (1). According to the invention a receiver (2, 3, 4) is used comprising an antenna with synthetic aperture control and a processor which correlates the received signals after scattering from the ground with the transmitted signal and which applies range processing to the correlated signal. Moreover, the signal power of the processed signals for any scattering point in the map area is registered.

Fig. 1

## Description

This invention relates to the measurement of the field strength map of a HF broadcast transmitter.

Since the introduction of cellular telephone systems over a decade ago the growth of various wireless communication systems has been rapid. This growth will still be accelerated in future as the demand for unlimited access in time or space to telephone and data services continues to increase while the prices decrease.

With this fast growing number of wireless services an efficient management of the frequency spectrum becomes important in order to avoid interferences between base station transmitters and to insure total coverage of the territory. This implies a sound knowledge of the field strength all over the territory.

Field strength measurements are usually made by a specially equipped van which drives around in the respective territory and measures the field strength in selected frequency ranges. However, the results of these measurements depend on weather conditions and transitional or permanent new obstacles (new buildings). Moreover, they are only valid along the roads and the values between measured lines must be interpolated.

The invention aims to provide a method for measuring the field strength map of a HF broadcast transmitter which transmits a signal of a given bandwidth. This receiver should provide an instant map of the field intensity of at least a portion of the entire territory of coverage of said transmitter thereby rendering superfluous the costly and time-consuming campaigns with field strength measuring cars.

This aim is achieved by the method as defined in claim 1 and by the receiver as defined in claim 2 or 3.

The invention will now be described in more detail by means of a preferred embodiment and the enclosed drawings.

Fig. 1 shows schematically different possibilities of locating the receiver according to the invention.

Fig. 2 represents a schematic block diagram of a receiver according to the invention.

Generally speaking, the invention uses synthetic radar imaging methods which are well known in the field of modern radar detection (see for example J.C. Currlander, R.N. McDonough "Synthetic Aperture Radar-Systems and Signal Processing" 1991 John Wiley & Sons).

An electromagnetic wave is reflected on an ideal ground surface at an angle identical to the incidence angle. Since the ground is not ideal but rough, it creates reflections which are scattered into all possible directions. A part of these reflections is scattered to a receiver which may be located close to the transmitter (backscattering) or else-where. The signal received in the receiver contains, in correlation with the original transmitted signal, all the phase information needed to reconstruct an image of the area from which the scattering has occurred.

Obviously the same scattering mechanism occurs for a communication signal broadcasted for example by a GSM base station during operation. In contrast to an ordinary radar system with a common high gain antenna for transmitting and receiving signals, the receiver according to the present invention cooperates with a commercial base station of a cellular communication system such as GSM whose antenna only transmits signals with low antenna gain $G_t$ at rather high frequencies, in general omnidirectionally.

The invention proposes to extract from the scattered signal not only the image of the area, by applying synthetic aperture techniques in the control of the receiver antenna and range processing of the correlated received signals as it is known from synthetic radar systems, but also for each individual scattered signal the power $P_r$ which amounts for any point within the range of the transmitter and the receiver to:

$$P_r = P_t G_t G_r \lambda^2 \sigma / \{(4\pi)^3 R_t^2 R_r^2\}$$

In this formula the indices r and t signify "receive" and "transmit" respectively, P is the power, G the antenna gain, $\lambda$ the wavelength, $\sigma$ the radar cross-section and R the distance.

If the receiver is close to the base station the distances $R_t$ and $R_r$ become equal. This is the simplest case because the correlation between transmitted and received signals is facilitated by feeding the transmit signal directly into the signal processor of the receiver. However, this is not mandatory, and the receiver can be alternatively be mounted remote from the transmitter on another summit point or it can even be airborne. The correlation in these cases uses the signal which has been directly received in the receiver from the transmitter without scattering on the ground.

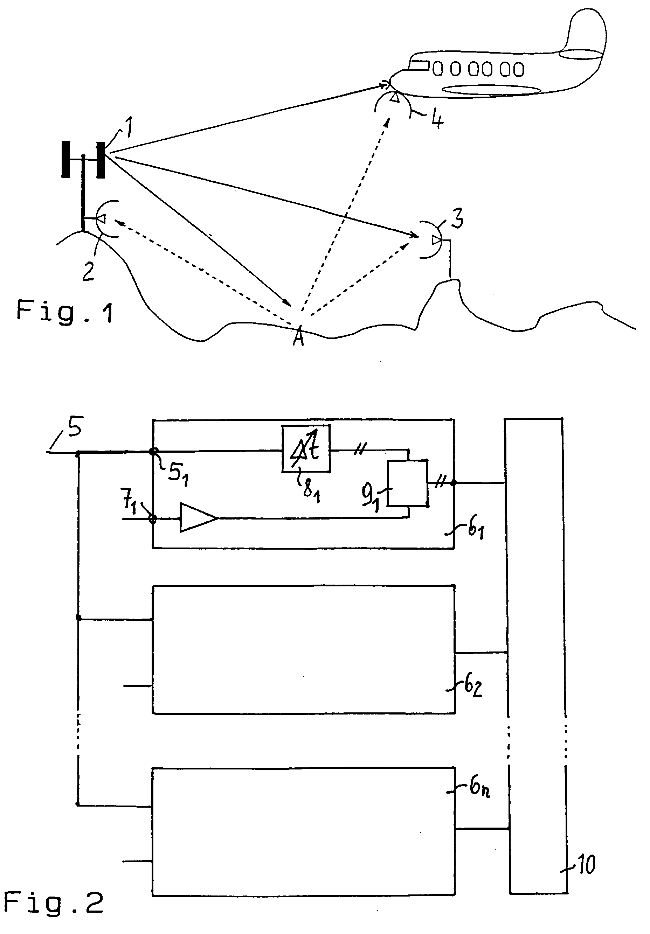

Fig. 1 shows these possibilities for a given scattering point A in the area. The continuous lines signify signals broadcasted by a transmitter 1, whereas the interrupted lines signify the way of the scattered signals from said scattering point A to the receiver 2 (close to the transmitter) or 3 (at a distance from the transmitter) or 4 (airborne).

Fig. 2 shows the set-up of the receiver 2 or 3 or 4 of figure 1. It receives either through a cable (in the case of a receiver located close to the broadcasting transmitter) or through direct radio transmission the transmitted signal via a first input 5. The scattered signal response is presented to individual distance channels $6_i$ (i = 1, 2, ...n) via an input $7_i$. In each channel the directly transmitted signal received through a channel input $5_1$ is applied to a delay lines $8_i$ whose time lag defines the distance range of this channel. A channel correlator $9_i$ correlates the delayed directly transmitted signal with the scattered signal. The output of the correlator $9_i$ is the response of the respective channel $6_i$ at a distance corresponding to the time lag of the delay line $8_i$. All the correlation results are fed to a common so-called and well known Synthetic Aperture Radar processor 10 which is programmed to establish a coverage map, that is a map of the power of the signals scattered from any detectable scattering point A.

The system performance depends of course on the available transmitted signal. For the case of a GSM cellular telephone system the maximum resolution in range amounts to about 75 meters for a single channel (200 kHz) or to 6 meters if all downlink channels are used coherently (25 MHz). These values demonstrate clearly that a quality control with this radar imaging approach gives a resolution comparable to the resolution obtained with conventional methods as mentioned above. But unlike these conventional methods the obtained resolution is available instantly for the entire coverage area without circulating with a field strength measuring van.

The achievable resolution in cross-range depends strongly on the available aperture and the frequency. For the case of GSM, the same resolution is achieved as for a range of 6 meters within a distance of 1 km using an aperture of 25 metres. Although this seems to be quite a large aperture, it should be kept in mind that with synthetic aperture methods it is sufficient to move the antenna along a path of these 25 meters and to sample according to the desired field of view.

The cross range resolution becomes still more favourable for future transmitters operating at frequencies above 1 GHz. Future wireless systems (microcellular or even pico-cellular systems) will therefore become more and more suited for the method according to the invention.

**Claims**

1. A method for measuring the field intensity map of a HF transmitter broadcasting a signal of a given bandwidth, characterized in that a receiver is used comprising an antenna with synthetic aperture control and a processor which correlates the received signals after scattering from the ground with the transmitted signal and which applies range processing to the correlated signal, and that the signal power of the processed signals for any scattering point in the map area is registered.

2. A receiver (2) for implementing the method according to claim 1, characterized in that it is mounted close to the transmitter (1) and is coupled to the transmitter in order to receive directly the transmitted signal for correlation purposes.

3. A receiver (4) for implementing the method according to claim 1, characterized in that it is mounted on an airplane, its antenna being directed substantially vertically towards the ground, and that it is provided with an additional directional antenna receiving along a direct path the transmitter (1) signal for correlation purposes.

4. A receiver for implementing the method according to claim 1, characterized in that it comprises a plurality of correlation channels ($6_i$) which receive via a first input ($5_i$) the transmitted signal and via a second input ($7_i$) a scattered response signal and which supply to a common synthetic aperture radar processor (10) the information needed for calculating the power of the scattered signal at selectable distance ranges and directions.

Fig. 1

Fig.2

# EP 0 949 831 A1

**European Patent Office**

## EUROPEAN SEARCH REPORT

Application Number

EP 98 10 6337

### DOCUMENTS CONSIDERED TO BE RELEVANT

| Category | Citation of document with indication, where appropriate, of relevant passages | Relevant to claim | CLASSIFICATION OF THE APPLICATION (Int.Cl.6) |
|---|---|---|---|
| A | BEDFORD: "A COMPARISON OF MEASURED AND PREDICTED, 800 MHZ, LAND-MOBILE-RADIO SIGNALS" 37TH IEEE VEHICULAR TECHNOLOGY CONFERENCE, 1 - 3 June 1987, pages 137-144, XP002078646 TAMPA, FLORIDA, USA * page 138, left-hand column, paragraph 2 - page 140, right-hand column, paragraph 2 * | 1 | H04Q7/34 G01S13/90 G01R29/08 |
| A | US 5 179 383 A (RANEY ET AL.) 12 January 1993 * column 1, line 22 - column 7, line 2 * | 1-3 | |
| A | US 4 305 153 A (KING) 8 December 1981 * column 1, line 10 - column 2, line 68; figures 1-3 * | 1 | |
| A | GB 2 260 050 A (NEC) 31 March 1993 * abstract * * page 6, line 10 - line 21; figures 1,8 * | 1 | TECHNICAL FIELDS SEARCHED (Int.Cl.6) |
| A | LEJERKRANS J E ET AL: "FIELD STRENGTH MEASUREMENT AND ANTENNA RADIATION PATTERN PLOTTING USING HELI-BORNE EQUIPMENT" PROCEEDINGS OF THE INTERNATIONAL BRAODCASTING CONVENTION, BRIGHTON, 23 - 27 SEPT., 1988,23 September 1988, pages 137-142, XP000232924 INSTITUTION OF ELECTRICAL ENGINEERS * the whole document * | 1 | H04Q G01S G01R |

The present search report has been drawn up for all claims

| Place of search | Date of completion of the search | Examiner |
|---|---|---|
| THE HAGUE | 24 September 1998 | Iwansson, K |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

5

EP 0 949 831 A1

## ANNEX TO THE EUROPEAN SEARCH REPORT
## ON EUROPEAN PATENT APPLICATION NO.

EP 98 10 6337

This annex lists the patent family members relating to the patent documents cited in the above-mentioned European search report.
The members are as contained in the European Patent Office EDP file on
The European Patent Office is in no way liable for these particulars which are merely given for the purpose of information.

24-09-1998

| Patent document cited in search report | | | Publication date | Patent family member(s) | | | Publication date |
|---|---|---|---|---|---|---|---|
| US 5179383 | A | | 12-01-1993 | AU<br>CA<br>WO | 2301392<br>2091464<br>9302368 | A<br>A<br>A | 23-02-1993<br>16-01-1993<br>04-02-1993 |
| US 4305153 | A | | 08-12-1981 | US<br>CA | 4195262<br>1143055 | A<br>A | 25-03-1980<br>15-03-1983 |
| GB 2260050 | A | | 31-03-1993 | JP<br>US | 5067996<br>5423067 | A<br>A | 19-03-1993<br>06-06-1995 |

EPO FORM P0459

For more details about this annex : see Official Journal of the European Patent Office, No. 12/82

6